# EUROPÄISCHE PATENTANMELDUNG

(11) **EP 3 979 009 A1**
(43) Veröffentlichungstag der Anmeldung: **06.04.2022**
(21) Anmeldenummer: 21198877.9
(22) Anmeldetag: 24.09.2021
(51) Int. Cl.: G05B 13/02, G05B 17/02

(54) **ERZEUGEN EINES VEREINFACHTEN MODELLS FÜR XIL-SYSTEME**

(30) Priorität: 02.10.2020 DE 102020212505
(71) Anmelder: Ford Global Technologies, LLC, Dearborn, MI 48126 (US)
(72) Erfinder: ASLANDERE, Turgay, 52062 Aachen (DE)
(74) Vertreter: Haseltine Lake Kempner LLP

(57) **Zusammenfassung**

Die Erfindung betrifft ein Verfahren für ein vereinfachtes Model zur Anwendung in einem XiL-System b mit folgenden Schritten: Bestimmen eines festgelegten Parameters, welcher die Komplexität eines Modells quantitativ charakterisiert, für ein Ausgangsmodell (1); Generieren von Eingangsdaten und Ausgangsdaten des Ausgangsmodells (2); Trainieren eines neuronalen Netzwerks mittels einer Trainingsmenge der generierten Eingangsdaten und Ausgangsdaten des Ausgangsmodells zur Erzeugung eines vereinfachten Modells, welches im Vergleich zum Ausgangsmodell eine geringere Komplexität aufweist und bei welchem ein festgelegter unterer Schwellenwert für die Zuverlässigkeit eines Modells quantitativ charakterisierenden Parameter überschritten wird (3); Erzeugen eines vereinfachten Modells mittels des trainierten neuronalen Netzwerks (4); Bestimmen eines die Komplexität charakterisierenden Parameters für das vereinfachte Modell (5); falls die bestimmte Komplexität des erzeugten vereinfachten Modells geringer ist als die des Ausgangsmodells (6), Testen des erzeugten vereinfachten Modells mittels einer von der Trainingsmenge abweichenden Testmenge der generierten Eingangsdaten und Ausgangsdaten des mindestens einen Ausgangsmodells und Bestimmen eines die Zuverlässigkeit charakterisierenden Parameters des erzeugten vereinfachten Modells (7); falls die bestimmte Zuverlässigkeit des vereinfachten Modells den festgelegten Schwellenwert überschreitet (8), Ausgeben des vereinfachten Modells (9).

## Beschreibung

Die vorliegende Erfindung betrifft ein Verfahren zum Erzeugen eines vereinfachten Models zur Anwendung in einem XiL-System. Die Erfindung betrifft weiterhin eine Vorrichtung zur Datenverarbeitung, ein Computerprogramm, eine Anordnung zur Durchführung XiL-Tests von Komponenten von Kraftfahrzeugen, insbesondere selbstfahrenden Kraftfahrzeugen, ein Verfahren zur Durchführung von XiL-Tests, ein computerlesbares Speichermedium und ein Datenträgersignal.

Selbstfahrende Kraftfahrzeuge (manchmal auch autonome Landfahrzeuge genannt) sind Kraftfahrzeuge, die ohne Einflussnahme eines menschlichen Fahrers fahren, steuern und einparken können (hochautomatisiertes Fahren bzw. autonomes Fahren). Im Falle, dass keinerlei manuelles Steuern seitens eines Fahrers nötig ist, wird auch der Begriff Roboterauto verwendet. Der Fahrersitz kann unbesetzt bleiben; eventuell sind kein Lenkrad, Brems- und Gaspedal vorhanden. Selbstfahrende Kraftfahrzeuge können mit Hilfe verschiedener Sensoren ihre Umgebung erfassen und aus den gewonnenen Informationen ihre Position und die anderer Verkehrsteilnehmer bestimmen, in Zusammenarbeit mit der Navigationssoftware ein Fahrziel ansteuern und Kollisionen auf dem Weg dahin vermeiden.

Das Aufkommen von intelligenten Mobilitätslösungen und automatisierten Fahrfunktionen bringt neue Herausforderungen beim Testen derartiger Systeme mit sich. Physisches Prototyping und/oder intensive reale Testfahrten sind extrem herausfordernd. Aus diesem Grund wurden in den letzten Jahren neue Technologien für das virtuelle Engineering entwickelt. Eine wichtige Voraussetzung für das Testen derartiger Systeme ist die Bereitstellung von X-in-the-Loop-Frameworks (XiL-Syteme), die das Testen der entwickelten Software auf verschiedenen Plattformen ermöglichen, wie z.B. MiL, SiL, HiL, DiL, mit echtem ECU, in realen Prototypen.

Bei den XiL-Tests kann es sich zum Beispiel um MiL (Model-in-the-Loop), SiL (Software-in-the-Loop), HiL (Hardware-in the-Loop) und/oder DiL (Driver-in-the-Loop) handeln. MiL umfasst dabei den Aufbau von Modellen für eine Regelstrecke und ein ECU sowie eine Regelungslogik mit Regelungsstrategie zur Verhaltenssimulation, SiL das Erstellen von Modellen in der Zielsprache des ECUs zum automatisierten Testen im Softwareentwicklungen, HiL bezeichnet ein Verfahren, bei dem ein eingebettetes System (z B. reales elektronisches ECU oder reale mechatronische Komponente, die Hardware) über seine Ein- und Ausgänge an ein angepasstes Gegenstück angeschlossen wird, und unter DiL eine Kombination der HIL-Simulation mit einem Fahrsimulator in einer DIL-Simulationsumgebung verstanden.

Unter einem ECU bzw. Steuergerät wird dabei ein elektronisches Modul verstanden, die dazu ausgebildet sind, z.B. unter Verwendung einer Steuer- oder Steuer- oder Regelstrategie andere Komponenten, wie Komponenten eines Kraftfahrzeugs zu steuern oder zu regeln. Typischerweise werden bei den Tests mindestens ein ECU, das die zu prüfende Software aufweist, und ein Modell, das das Verhalten des Systems nachahmt, verwendet.

In dem Dokument DE 10 2018 206 188 A1 wird ein System zum Durchführen von XiL-Tests von Komponenten selbstfahrender Kraftfahrzeuge beschrieben, wobei Tests auf einer Mehrzahl von XiL-Plattformen ausgeführt werden können. In dem Dokument US 2019/0303759 A1 wird die Anwendung neuronaler Netzwerke zum Testen eines virtuellen Fahrzeuges in einer simulierten Umgebung beschrieben, wobei die zum Trainieren des neuronalen Netzwerks verwendeten physikalischen Sensordaten durch ein Fahrzeug in einer realen Umgebung generiert werden.

Zum Testen von Software, mit welcher spezifische Funktionen autonom umgesetzt werden soll, werden üblicherweise XiL-Elemente verwendet. Dabei werden beispielsweise als Software-Modelle (software in loop), Hardware-Modelle (hardware in loop, processor in loop) zur Gestaltung des Test- und Überprüfungsprozesses verwendet um insbesondere Kosten für Prototypen und die Durchführung von realen Tests zu verringern. Aufgrund der steigenden Anzahl an Hardware- und Software-Elementen in Kraftfahrzeugsystemen, beispielsweise in Fahrerassistenzsystemen, und der zunehmenden Anzahl an Antriebsstrangelementen steigt die Anzahl an erforderlichen Tests bevor ein Prototyp herausgegeben werden kann. Als Folge davon steigt ebenfalls die Anzahl an XiL-Modellen, welche für verschiedene Ausgestaltungen und Tests erforderlich sind.

Abgesehen davon werden diese Modelle zunehmend komplexer, rechentechnisch aufwendiger und damit teurer. Darüber hinaus sollten die Modelle dazu in der Lage sein, in Echtzeit zu arbeiten bzw. eine Performance in Echtzeit bieten. Dies ist insbesondere im Zusammenhang mit Test- und Verifikationsprozessen von Bedeutung. Allerdings erfordern die heutigen sehr komplexen Modelle ein hohes Maß an Rechenkapazität um in Echtzeit ausgeführt werden zu können. In dem Maß, in dem die Modelle komplexer werden, beispielsweise ADAS-Modelle, Antriebsstrangmodelle usw., kommen die bestehenden XiL-Recheneinheiten, welche Echtzeit-Prozessoren umfassen (z.B. dSpace Scalexio Boxes), an ihre Grenzen. Sie sind unter Umständen nicht in der Lage die erforderlichen Anforderungen zu erfüllen. Daher kann in so einem Fall ein entsprechendes komplexes Modell nicht angewendet werden.

Vor dem beschriebenen Hintergrund ist es Aufgabe der vorliegenden Erfindung, Verfahren und Vorrichtungen zum Generieren bzw. Erzeugen von einfacheren Modellen zur Verfügung zu stellen, wobei insbesondere der Entwicklungsaufwand und die Kosten für unter Umständen erforderliche Tests reduziert werden.

Diese Aufgaben werden durch ein Verfahren zum Erzeugen eines vereinfachten Models zur Anwendung in einem XiL-System gemäß Patentanspruch 1, eine Vorrichtung zur Datenverarbeitung gemäß Patentanspruch 8, einem Computerprogramm gemäß Patentanspruch 10, einer Anordnung zur Durchführung von XiL-Tests gemäß Patentanspruch 11, ein Verfahren zur Durchführung von XiL-Tests gemäß Patentanspruch 14, ein entsprechendes Computerprogramm gemäß Patentanspruch 15, ein computerlesbares Speichermedium gemäß Patentanspruch 16 und ein Datenträgersignal gemäß Patentanspruch 17 gelöst. Die abhängigen Ansprüche enthalten weitere vorteilhafte Ausgestaltungen der Erfindung.

Das erfindungsgemäße Verfahren zum Erzeugen eines vereinfachten Modells zur Anwendung in einem XiL-System, insbesondere auf mindestens einer XiL-Testplattform oder in einem XiL-Testverfahren, umfasst folgende Schritte: Es wird mindestens ein festgelegter Parameter, welcher die Komplexität eines Ausgangsmodells quantitativ charakterisiert, für mindestens ein Ausgangsmodell bestimmt. In einem weiteren Schritt werden Eingangs- und Ausgangsdaten des mindestens einen Ausgangsmodells generiert. In einem nächsten Schritt wird ein neuronales Netzwerk mittels einer Trainingsmenge der generierten Eingangsdaten und Ausgangsdaten des mindestens einen Ausgangsmodells zur Erzeugung, insbesondere zur Entwicklung, eines vereinfachten Modells, welches im Vergleich zu dem mindestens einen Ausgangsmodell eine geringere Komplexität aufweist und bei welchem ein festgelegter untere Schwellenwert für mindestens einen die Zuverlässigkeit eines Modells quantitativ charakterisierenden Parameter unterschritten wird, trainiert.

Mittels des trainierten neuronalen Netzwerks wird ein vereinfachtes Modell erzeugt. Der die Komplexität charakterisierende Parameter wird für das vereinfachte Modell bestimmt. Falls die bestimmte Komplexität des erzeugten vereinfachten Modells geringer ist als die des Ausgangsmodells, wird das erzeugte vereinfachte Modell mittels einer von der Trainingsmenge abweichenden Testmenge der generierten Eingangs- und Ausgangsdaten des mindestens einen Ausgangsmodells getestet. Dabei wird der mindestens eine, die Zuverlässigkeit charakterisierende Parameter des erzeugten vereinfachten Modells bestimmt. Falls die bestimmte Zuverlässigkeit des vereinfachten Modells den festgelegten Schwellenwert unterschreitet, wird das vereinfachte Modell ausgegeben.

Das Verfahren hat den Vorteil, dass durch den beschriebenen Einsatz eines neuronalen Netzwerkes die Entwicklungskosten für ein einfacheres und optimiertes Modell ausgehend von einem komplexen Modell reduziert werden und gleichzeitig auch die Kosten für den Test eines solchen Modells minimiert werden können. Weiterhin ist es möglich, komplexe und nicht echtzeitfähige Modelle in belastbare vereinfachte Modelle, welche für einen Betrieb in Echtzeit tauglich sind, zu überführen ohne dabei die Zuverlässigkeit des Modells unerwünscht zu reduzieren.

Der Parameter, welcher die Komplexität des Ausgangsmodells quantitativ charakterisiert, kann zum Beispiel die Anzahl der Rechenoperationen pro Eingangsdatum und/oder die erforderliche Rechenzeit zur Ausführung eines das Modell abbildenden Algorithmus und/oder der erforderliche Speicherplatzbedarf zur Ausführung eines das Modell abbildenden Algorithmus umfassen. Der Parameter, welcher die Zuverlässigkeit des Ausgangsmodells quantitativ charakterisiert, kann ein Maß für die Abweichung der durch das Modell erzeugten Ausgangsdaten von den erwarteten Ausgangsdaten, also den von einer realen Anwendungskomponente oder Anwendungsfunktion zu liefernden Ausgangsdaten, umfassen.

Durch eine entsprechende Auswahl und Festlegung von Parametern, welche die Komplexität eines Modells quantitativ charakterisieren und welche die Zuverlässigkeit desselben charakterisieren, lässt sich nachvollziehbar ermitteln, ob und in welchem Ausmaß das durch das neuronale Netzwerk generierte Modell im Vergleich zu dem Ausgangsmodell einfacher ist und ob und wie sich dies auf dessen Zuverlässigkeit auswirkt.

Das neuronale Netzwerk kann als tiefes neuronales Netzwerk ausgestaltet sein. Tiefe neuronale Netzwerke werden hauptsächlich dazu benutzt, Trainingsdaten zu generalisieren und Vorhersagen zu machen, wobei eine trainierte Gewichtung verwendet wird. Tiefe neuronale Netzwerke sind in der Lage, das Verhalten von komplexen Systemen zu erlernen. Dabei steigt die Zuverlässigkeit mit dem Umfang der zur Verfügung stehenden Daten. Da XiL-Modelle in der Lage sind eine unbegrenzte Anzahl an Trainingsdaten zu generieren, ist es möglich, dass tiefe neuronale Netzwerke das Verhalten dieser Modelle lernen und dazu in der Lage sind, mit hoher Präzision Vorhersagen zu machen. Tiefe neuronale Netzwerke eignen sich daher zur Transformation einzelner komplexer Modelle in allgemeinere und rechnerisch weniger aufwendige Modelle.

In einer weiteren Variante ist das mindestens eine Ausgangsmodell als Sequenz aus einer Anzahl an Modellen ausgestaltet. Mit anderen Worten, kann das Ausgangsmodell eine Anzahl an nacheinander anwendbaren Ausgangsmodellen aufweisen. Das neuronale Netzwerk kann als rekurrentes neuronales Netzwerk ausgestaltet sein. Dies ist insbesondere von Vorteil, wenn das Ausgangsmodell als Sequenz aus einer Anzahl an Modellen ausgestaltet ist. In diesem Fall können zwei oder mehr komplexe Ausgangsmodelle in ein einzelnes vereinfachtes Modell überführt werden. Dadurch wird die Komplexität des jeweiligen XiL-Systems deutlich vereinfacht und dessen Performance erheblich verbessert. Insbesondere kann auf diese Weise eine Echtzeit-Anwendung ermöglicht werden.

Ähnlich den tiefen neuronalen Netzwerken werden rekurrente neuronale Netzwerke (RNN recurrent neural networks) verwendet um Trainingsdaten zu generalisieren, welche aus Serien von Informationen aufgebaut sind. Rekurrente neuronale Netzwerke können einfach mittels Daten trainiert werden, welche aus Sequenzen von Eingangsdaten und Ausgangsdaten von Modellen, welche rechentechnisch aufwendig sind, bestehen. Jede RNN-Zelle kann eine zusätzliche eingebettete Schicht aufweisen, wo die Trainingsdaten kategoriale Variablen (categorical variables) einschließen. Weiterhin können die RNN-Zellen Eingangsdaten von einer gefalteten Netzwerkschicht empfangen. Das Aktivitätsdiagramm eines rekurrenten neuronalen Netzwerks zur Erzeugung vereinfachter Modelle ist dem eines neuronalen Netzwerks ähnlich aufgebaut.

Es ist von Vorteil, wenn in der Trainingsphase des neuronalen Netzwerks die Modelle leicht überfittet (overfit) werden, wobei die Trainingszuverlässigkeit höher ist als die Testzuverlässigkeit. Dies hat den Hintergrund, dass leicht überfittete AI-Modelle (AI ― artificial intelligence, künstliche Intelligenz) akkuratere Vorhersagen mit den wiederholten Eingangsdaten machen können, wenn genügend Daten zur Verfügung stehen. Im Falle eines stark überfitteten Modells können Regulationstechniken wie beispielsweise das Drop Out oder L2 und L1 zur Regulation angewendet werden.

Vorzugsweise ist das Verfahren zum Erzeugen eines Modells zur Simulation von mindestens einer Funktion eines Kraftfahrzeuges, vorzugsweise eines selbstfahrenden Kraftfahrzeuges, ausgelegt. Dabei kann es sich zum Beispiel um eine Fahrerassistenzfunktion und/oder eine Funktion des Antriebsstrangs des Kraftfahrzeuges handeln.

Die erfindungsgemäße Vorrichtung zur Datenverarbeitung umfasst Mittel zur Ausführung eines zuvor beschriebenen erfindungsgemäßen Verfahrens. Die Vorrichtung kann insbesondere eine Einrichtung zum Festlegen mindestens eines die Komplexität des Ausgangsmodells charakterisierenden Parameters und eine Einrichtung zum Bestimmen dieses Parameters aufweisen. Die Vorrichtung kann weiterhin eine Einrichtung zum Festlegen und/oder Bestimmen eines Parameters, welcher die Zuverlässigkeit eines Modells quantitativ charakterisiert umfassen.

Weiterhin kann die Vorrichtung eine oder mehrere Einrichtungen zum Generieren von Eingangs- und Ausgangsdaten mindestens eines Ausgangsmodells aufweisen. Die Vorrichtung umfasst vorzugsweise ein neuronales Netzwerk und einer Einrichtung zum Trainieren desselben. Darüber hinaus kann die Vorrichtung eine Einrichtung zum Ausgeben eines mittels des neuronalen Netzwerks generierten Modells aufweisen.

Die Vorrichtung zur Datenverarbeitung kann als Hardware-Element ausgestaltet sein, welches eine Recheneinheit zur Ausführung neuronaler Netzwerk-Algorithmen umfasst und zur Verbindung einer Anzahl an XiL-Einheiten bzw. XiL-Elementen ausgelegt ist. Bei der Recheneinheit kann es sich zum Beispiel um Raspberry Pi, dSpace Microbox oder um einen Computer handeln. Die Vorrichtung kann zum Beispiel über Kommunikationsschnittstellen zur Verbindung mit einer Anzahl an XiL-Einheiten verfügen, zum Beispiel USB-Schnittstellen, Ethernet-Schnittstellen, insbesondere TCB/IP, UDP-Stecker, oder CAN-Schnittstellen.

Das erfindungsgemäße Computerprogramm umfasst Befehle, die bei der Ausführung des Programms durch einen Computer diesen veranlassen, das oben beschriebene erfindungsgemäße Verfahren auszuführen.

Die erfindungsgemäße Anordnung, bei der es sich zum Beispiel um ein System handeln kann, zur Durchführung von XiL-Tests von Komponenten von Kraftfahrzeugen, beispielsweise von selbstfahrenden Kraftfahrzeugen, umfasst eine Mehrzahl an zur Datenübertragung miteinander verbundenen XiL-Modellen. Die Anordnung ist dazu ausgelegt, mindestens eines der XiL-Modelle durch ein mittels eines oben beschriebenen erfindungsgemäßen Verfahrens erzeugtes vereinfachtes Modell zu ersetzen. Dies hat den Vorteil, dass die Durchführung von XiL-Tests mittels der erfindungsgemäßen Anordnung rechentechnisch einfacher und gegebenenfalls in Echtzeit durchgeführt werden kann. Weiterhin weist die Anordnung im Vergleich zu bisher üblichen Ausgestaltungen eine reduzierte Komplexität auf und ist kostengünstig herzustellen.

In einer vorteilhaften Variante ist die Anordnung dazu ausgelegt, mehrere der XiL-Modelle durch ein Einzelnes, also ein gemeinsames, vereinfachtes Modell zu ersetzen, welches mittels eines oben beschriebenen erfindungsgemäßen Verfahrens erzeugt worden ist. In einer weiteren Variante kann die Anordnung eine oben beschriebene erfindungsgemäße Vorrichtung zur Datenverarbeitung und/oder ein oben beschriebenes erfindungsgemäßes Computerprogramm umfassen.

Das erfindungsgemäße Verfahren zur Durchführung von XiL-Tests, insbesondere von Komponenten von Kraftfahrzeugen, zum Beispiel selbstfahrenden Kraftfahrzeugen, umfasst folgende Schritte: In einem ersten Schritt wird ein XiL-System, welches mindestens ein Ausgangsmodell umfasst, initialisiert. In einem nächsten Schritt wird ein vereinfachtes Modell des mindestens einen Ausgangsmodells mittels eines oben beschriebenen erfindungsgemäßen Verfahrens erzeugt. Anschließend wird mindestens ein oder das mindestens eine Ausgangsmodell durch das vereinfachte Modell in dem XiL-System ersetzt. Anschließend wird der XiL-Test mit dem das vereinfachte Modell umfassenden XiL-System durchgeführt. Das erfindungsgemäße Verfahren zur Durchführung von XiL-Tests hat die oben bereits genannten Vorteile. Es ist insbesondere in Echtzeit durchführbar und ermöglicht ein flexibles und effizientes Überführen von komplexen Teilmodellen des XiL-Systems in vereinfachte und leistungsfähigere Modelle.

Das erfindungsgemäße Computerprogramm zur Durchführung von XiL-Tests umfasst Befehle, die bei der Ausführung des Programms durch einen Computer diesen veranlassen, ein zuvor beschriebenes erfindungsgemäßes Verfahren zur Durchführung von XiL-Tests auszuführen. Es hat die bereits genannten Vorteile.

Das erfindungsgemäße computerlesbare Speichermedium umfasst Befehle, die bei der Ausführung durch einen Computer diesen veranlassen, ein oben beschriebenes erfindungsgemäßes Verfahren zum Erzeugen eines vereinfachten Modells zur Anwendung in einem XiL-System und/oder ein oben beschriebenes erfindungsgemäßes Verfahren zur Durchführung von XiL-Tests auszuführen. Das erfindungsgemäße Datenträgersignal überträgt eines der bereits beschriebenen Computerprogramme, also ein Computerprogramm zum Erzeugen eines vereinfachten Modells zur Anwendung in einem XiL-System und/oder ein Computerprogramm zur Durchführung von XiL-Tests.

Die vorliegende Erfindung hat insgesamt den Vorteil, dass sie die Erstellung XiL-Systemen ermöglicht, welche auch für komplexe Modelle in Echtzeit mit reduziertem Rechenaufwand unter reduzierten technischen Anforderungen durchführbar sind.

Die Erfindung wird im Folgenden anhand von Ausführungsbeispielen unter Bezugnahme auf die beigefügten Figuren näher erläutert. Obwohl die Erfindung im Detail durch die bevorzugten Ausführungsbeispiele näher illustriert und beschrieben wird, so ist die Erfindung nicht durch die offenbarten Beispiele eingeschränkt und andere Variationen können vom Fachmann hieraus abgeleitet werden, ohne den Schutzumfang der Erfindung zu verlassen.

Die Figuren sind nicht notwendigerweise detailgetreu und maßstabsgetreu und können vergrößert oder verkleinert dargestellt sein, um einen besseren Überblick zu bieten. Daher sind hier offenbarte funktionale Einzelheiten nicht einschränkend zu verstehen, sondern lediglich als anschauliche Grundlage, die dem Fachmann auf diesem Gebiet der Technik Anleitung bietet, um die vorliegende Erfindung auf vielfältige Weise einzusetzen.

Der hier verwendete Ausdruck "und/oder", wenn er in einer Reihe von zwei oder mehreren Elementen benutzt wird, bedeutet, dass jedes der aufgeführten Elemente alleine verwendet werden kann, oder es kann jede Kombination von zwei oder mehr der aufgeführten Elemente verwendet werden. Wird beispielsweise eine Zusammensetzung beschrieben, dass die Komponenten A, B und/oder C, enthält, kann die Zusammensetzung A alleine; B alleine; C alleine; A und B in Kombination; A und C in Kombination; B und C in Kombination; oder A, B, und C in Kombination enthalten.
- Fig. 1: zeigt schematisch das erfindungsgemäße Verfahren zum Erzeugen eines vereinfachten Models zur Anwendung in einem XiL-System in Form eines Flussdiagramms.
- Fig. 2: zeigt schematisch eine erste Variante einer erfindungsgemäßen Anordnung zur Durchführung von XiL-Tests und deren Funktionsweise unter Verwendung eines tiefen neuronalen Netzwerks in Form eines Blockdiagramms.

- Fig. 3: zeigt schematisch eine zweite Variante einer erfindungsgemäßen Anordnung zur Durchführung von XiL-Tests und deren Funktionsweise unter Verwendung eines rekurrenten neuronalen Netzwerks in Form eines Blockdiagramms.
- Fig. 4: zeigt schematisch ein erfindungsgemäßes Verfahren zur Durchführung von XiL-Tests in Form eines Flussdiagramms.

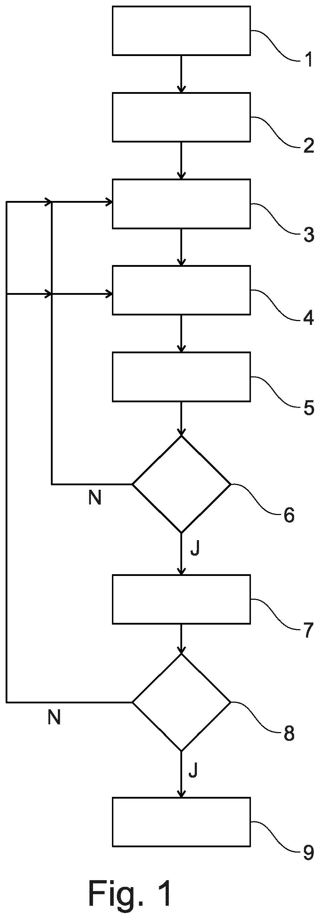

Im Folgenden wird das erfindungsgemäße Verfahren zum Erzeugen eines vereinfachten Modells zur Anwendung in einem XiL-System anhand der Figur 1 näher erläutert. In einem ersten Schritt 1 wird mindestens ein festgelegter Parameter, welcher die Komplexität eines Modells quantitativ charakterisiert, für mindestens ein Ausgangsmodell bestimmt. Dabei kann der Parameter im Rahmen des Verfahrens festgelegt werden oder bereits festgelegt und vorgegeben sein. Es können auch mehrere festgelegte Parameter für das Ausgangsmodell bestimmt werden, welche dessen Komplexität quantitativ charakterisieren.

In einem nächsten Schritt 2 werden Eingangsdaten und Ausgangsdaten des mindestens einen Ausgangsmodells generiert. In Schritt 3 wird ein neuronales Netzwerk mittels einer Trainingsmenge der generierten Eingangsdaten und Ausgangsdaten des mindestens einen Ausgangsmodells zur Erzeugung oder Entwicklung eines vereinfachten Modells trainiert, wobei das vereinfachte Modell im Vergleich zu dem mindestens einen Ausgangsmodell eine geringere Komplexität aufweist und wobei ein festgelegter unterer Schwellenwert für mindestens einen die Zuverlässigkeit eines Modells quantitativ charakterisierenden Parameter überschritten wird.

Sowohl der mindestens eine die Zuverlässigkeit eines Modells quantitativ charakterisiere Parameter, als auch der darauf bezogene Schwellenwert können vorgegeben sein oder im Rahmen des Verfahrens individuell festgelegt werden.

In einem vierten Schritt 4 wird ein vereinfachtes Modell mittels des trainierten neuronalen Netzwerks erzeugt. In einem fünften Schritt wird der die Komplexität charakterisierendes mindestens eines Parameters für das vereinfachte Modell bestimmt. In einem sechsten Schritt 6 wird geprüft, ob die bestimmte Komplexität des erzeugten einfachen Modells geringer ist, als die es Ausgangsmodells. Ist dies der Fall, so wird in Schritt 7 das erzeugte vereinfachte Modell mittels einer von der Trainingsmenge abweichenden Testmenge der generierten Eingangsdaten und Ausgangsdaten des mindestens einen Ausgangsmodells getestet und der mindestens eine, die Zuverlässigkeit charakterisierende Parameter des erzeugten vereinfachten Modells bestimmt. Falls in Schritt 6 die bestimmte Komplexität des erzeugten vereinfachten Modells nicht geringer ist als die des Ausgangsmodels, so springt das Verfahren zu Schritt 3 oder 4 zurück.

Im Anschluss an Schritt 7 wird in Schritt 8 wird geprüft, ob die bestimmte Zuverlässigkeit des vereinfachten Modells den festgelegten Schwellenwert überschreitet. Ist dies der Fall, so wird in Schritt 9 das vereinfachte Modell ausgegeben. Ist dies nicht der Fall, so springt das Verfahren zu Schritt 3 oder 4 zurück.

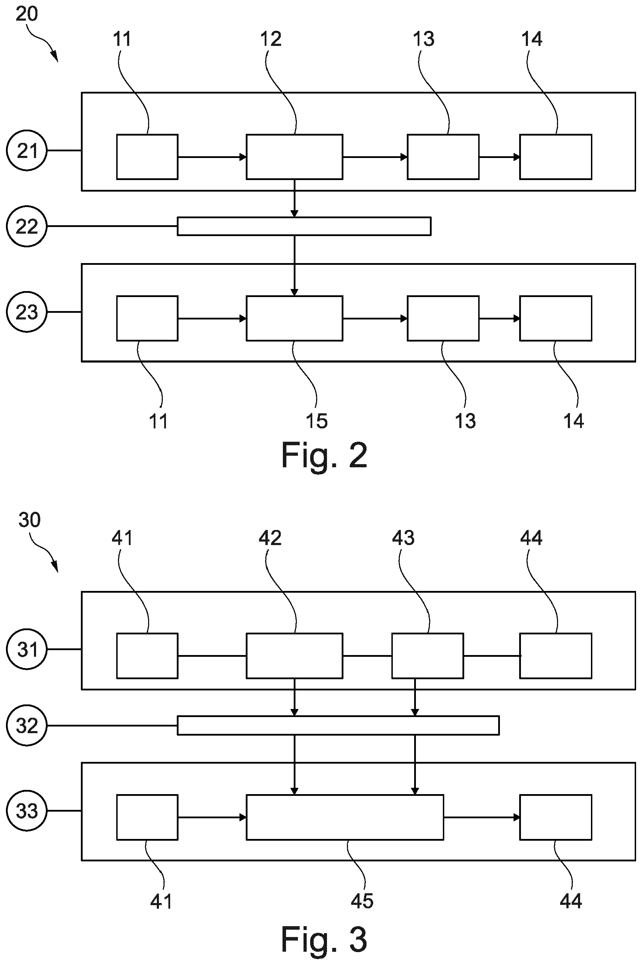

Die Figur 2 veranschaulicht die vorliegende Erfindung, konkret eine erste Variante einer erfindungsgemäßen Anordnung zur Durchführung von XiL-Tests 20 und deren Funktionsweise für den Fall der Verwendung eines tiefen neuronalen Netzwerks in Form eines Blockdiagramms. Block 21 ist ein XiL-System bzw. eine Anordnung zur Durchführung von XiL-Tests, welches bzw. welche eine Anzahl an XiL-Modellen umfasst.

Ein XiL-Modell A mit der Bezugsziffer 11 gekennzeichnet. Ein XiL-Modell B mit der Bezugsziffer 12 und ein XiL-Modell C mit der Bezugsziffer 13 gekennzeichnet. Weiterhin umfasst das XiL-System 21 eine Fahrzeughardware-Komponente 14. Das XiL-System 21 ist so ausgestaltet, dass Ausgangsdaten des XiL-Modells A 11 die Eingangsdaten des XiL-Modells B 12 darstellen und Ausgangsdaten des XiL-Modells B 12 die Eingangsdaten des XiL-Modells C 13 bilden. Die Ausgangsdaten des XiL-Modells C 13 bilden die Eingangsdaten für die Hardware-Komponente 14. In der gezeigten Variante ist das XiL-Modell B 12 so komplex, dass es nicht in Echtzeit ausführbar ist.

Die gezeigten XiL-Einheiten und die zugrundeliegenden Modelle 11, 12 und 13 sind vorzugsweise spezifischen Fahrzeugkomponenten oder Fahrzeugfunktionen zugeordnet. Zum Beispiel kann das XiL-System 21 ein Fahrerassistenzsystem, auch ADAS-System (Advanced Driver Assistance Systems) genannt, repräsentieren. Dabei kann das XiL-Modell A 11 ein Sensor-Modell repräsentieren, das XiL-Modell B 12 ein ADAS ECU Modell und das XiL-Modell C 13 eine Motorsteuereinheit bzw. ECU abbilden, wobei die Fahrzeughardware auf einem Rollenprüfstand (Chassis-Dynamometer) stattfinden kann. Diese Modelle können auch in einer Recheneinheit, zum Beispiel dSpace Micro Box, mit einer I/O-Schnittstelle ausgeführt werden. Sie können ebenso Teil eines modellbasierten Simulationssystems bzw. eines entsprechenden Tool-Sets sein.

Block 22 in der Figur 2 stellt eine Einrichtung zum Vereinfachen eines Modells mittels eines tiefen neuronalen Netzwerks (DNN) dar, im Folgenden als Modell-Vereinfacher abgekürzt. Dabei kann es sich um eine Einrichtung, zum Beispiel ein Computerprogramm handeln, welches dazu ausgelegt ist, ein anhand der Figur 1 beschriebenes Verfahren auszuführen. Mittels des Modell-Vereinfachers 22 wird das komplexe XiL-Modell B 12 in ein AI-basiertes, also auf künstlicher Intelligenz basierendes, Modell überführt, welches in Echtzeit ausgeführt werden kann. Dazu wird in dem System 21 das XiL-Modell B 12 durch das auf diese Weise neu generierte AI-basierte XiL-Modell B 15 ersetzt. Das auf diese Weise neu generierte XiL-System ist in der Figur 2 als Block 23 dargestellt. Es umfasst die Komponenten des XiL-Systems 21, wobei das XiL-Modell B 12 durch das XiL-Modell B 15 ersetzt wurde.

Das neue XiL-System 23 ist im Gegensatz zu dem XiL-System 21 in Echtzeit ausführbar. Es benötigt insbesondere zu seiner Ausführung weniger Rechenleistung und erfordert geringere technische Anforderungen. Das neue AI-basierte XiL-Modell B 15 beinhaltet trainierte Gewichte des Modells und wird ausschließlich für Vorhersagen verwendet. Es kann zum Beispiel in einer Rechen-Hardwareumgebung, zum Beispiel dSpace Microbox, Raspberry Pi oder auf dem Desktop eines Computers, ausgeführt werden. Es kann auch mit anderen XiL-Modellen über verschiedene Kommunikationsschnittstellen, zum Beispiel CAN, Ethernet (TCP/IP, UDP-Stecker, etc.), verbunden sein bzw. werden. Analog nutzt der Modell-Vereinfacher 22 eine Rechen-Hardwareumgebung. Diese benötigt allerdings hohe Performanceanforderungen und eine hohe Rechenleistung, da in diesem Rahmen ein neuronales Netzwerk trainiert werden muss und es sich bei dem Training einen rechentechnisch aufwendigen Prozess handelt.

Eine weitere Ausführungsvariante einer Anordnung zur Durchführung von XiL-Tests 30 ist in der Figur 3 in Form eines Blockdiagramms gezeigt. In dieser Variante umfasst das Ausgangs-XiL-System 31 vier hintereinander geschaltete XiL-Modelle A, B, C und D, welche mit den Bezugsziffern 41 bis 44 gekennzeichnet sind und bei welchen jeweils die Ausgangsdaten des vorgeschalteten Modells die Eingangsdaten des nachgeschalteten Modells bilden. Aufgrund der hohen Komplexität der XiL-Modelle B 42 und C 43 ist das System 31 nicht in Echtzeit ausführbar. Daher werden mittels eines Modell-Vereinfachers, welcher als Block 32 dargestellt ist, die XiL-Modelle B 42 und C 43 in ein gemeinsames XiL-Modell 45 transformiert. Dies erfolgt unter Verwendung eines rekurrenten neuronalen Netzwerks (RNN), vorzugsweise gemäß einem in der Figur 1 dargestellten Verfahren. Das so erzeugte, die XiL-Modelle B 42 und C 43 ersetzende AI-basierte XiL-Model 45 ist weniger komplex als die XiL-Modelle B 42 und C 43 und erfordert in seiner Anwendung einen geringeren technischen Aufwand.

Das Generieren des AI-basierten XiL-Modells 45 kann in einer Recheneinheit wie beispielsweise in Raspberry Pi, dSpace Microbox oder einem Computer erfolgen. Das so generierte Modell schließt trainierte Gewichte des Modells ein und wird ausschließlich für Vorhersagen verwendet. Das generierte XiL-Modell 45 ist dazu ausgelegt, mit anderen XiL-Vorrichtungen, zum Beispiel den XiL-Modellen A 41 und D 44 zur Datenübertragung verbunden zu werden. Dazu weist das generierte AI-basierte XiL-Modell 45 Kommunikationsschnittstellen auf, welche zum Beispiel eine Kommunikation insbesondere mit CAN und Ethernet erlauben.

Der Modell-Vereinfacher 32 wird ebenfalls in einer Rechenumgebung ausgeführt, die allerdings eine höhere Rechenleistung erfordert, als die Ausführung des XiL-Systems 33. Das Trainieren des rekurrenten neuronalen Netzwerks 32 erfolgt analog zu dem in der Figur 2 gezeigten tiefen neuronalen Netzwerk 22. Im Ergebnis des in der Figur 3 gezeigten Verfahrens wird ein neues XiL-System 33 erzeugt, in welchem die XiL-Modelle B 42 und C 43 durch das XiL-Modell 45 ersetzt sind und dadurch eine Ausführung des Systems in Echtzeit ermöglicht wird.

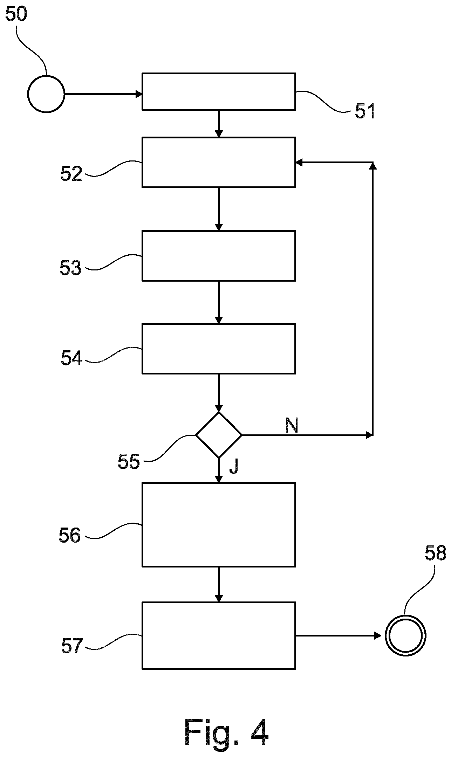

Die Figur 4 zeigt schematisch ein Flussdiagramm, welches das Genieren eines AI-basierten vereinfachten Modells am Beispiel eines tiefen neuronalen Netzwerks beschreibt und dessen Anwendung im Rahmen eines Verfahrens zur Durchführung von XiL-Tests veranschaulicht. Das Verfahren kann analog auch für ein rekurrentes tiefes neuronales Netzwerk angewendet werden.

Nach dem Start des Verfahrens 50 wird in Schritt 51 XiL-System initialisiert, zum Beispiel ein in der Figur 2 mit der Bezugsziffer 21 gekennzeichneten XiL-System oder ein in der Figur 3 mit der Bezugsziffer 31 gekennzeichnetes XiL-System. Anschließend werden in Schritt 52 Eingangs- und Ausgangsdaten von dem Modell geniert, welches für eine echtzeit-Anwendung zu komplex ist, also beispielsweise für das XiL-Modell B 12 in der Figur 2 oder die XiL-Modelle B 42 und C 43 in der Figur 3. Anschließend werden in Schritt 53 die generierten Daten zum Trainieren eines neuronalen Netzwerks, z.B. eines tiefen neuronalen Netzwerkes oder eines rekurrenten tiefen neuronalen Netzwerks verwendet, um ein vereinfachtes XiL-Modell zu erzeugen.

In Schritt 54 wird ein mittels des neuronalen Netzwerks erzeugte Modell in Bezug auf seine Zuverlässigkeit mittels der in Schritt 52 generierten Ein- und Ausgangsdaten getestet. In Schritt 55 wird die Zuverlässigkeit im Hinblick auf einen definierten Grenzwert überprüft. Unterschreitet die Zuverlässigkeit den festgelegten Grenzwert, so springt das Verfahren zu Schritt 52 zurück. Überschreitet die Zuverlässigkeit den festgelegten Grenzwert, so wird in Schritt 56 das komplexe Ausgangsmodell, also beispielsweise das XiL-Modell B 12 in Figur 2 oder die XiL-Modelle B 42 und C 43 in der Figur 3, durch das generierte AI-basierte XiL-Modell, also beispielsweise das XiL-Modell 15 in Figur 2 oder das XiL-Modell 45 in der Figur 3, ersetzt. Anschließend wird in Schritt 57 das XiL-System mit dem ersetzten Modell gestartet und das Verfahren mit Schritt 58 beendet.

### Bezugszeichenliste

- 1: Bestimmen mindestens eines festgelegten Parameters, welcher die Komplexität eines Modells quantitativ charakterisiert, für mindestens ein Ausgangsmodell
- 2: Generieren von Eingangsdaten und Ausgangsdaten des mindestens einen Ausgangsmodells
- 3: Trainieren eines neuronalen Netzwerks mittels einer Trainingsmenge der generierten Eingangsdaten und Ausgangsdaten des mindestens einen Ausgangsmodells zur Erzeugung eines vereinfachten Modells, welches im Vergleich zu dem mindestens einen Ausgangsmodell eine geringere Komplexität aufweist und bei welchem ein festgelegter unterer Schwellenwert für mindestens einen die Zuverlässigkeit eines Modells quantitativ charakterisierenden Parameter überschritten wird
- 4: Erzeugen eines vereinfachten Modells mittels des trainierten neuronalen Netzwerks
- 5: Bestimmen des mindestens einen, die Komplexität charakterisierenden Parameters für das vereinfachte Modell
- 6: Prüfen, ob die bestimmte Komplexität des erzeugten vereinfachten Modells geringer ist als die des Ausgangsmodells
- 7: falls die bestimmte Komplexität des erzeugten vereinfachten Modells geringer ist als die des Ausgangsmodells, Testen des erzeugten vereinfachten Modells mittels einer von der Trainingsmenge abweichenden Testmenge der generierten Eingangsdaten und Ausgangsdaten des mindestens einen Ausgangsmodells und Bestimmen des mindestens einen, die Zuverlässigkeit charakterisierenden Parameters des erzeugten vereinfachten Modells
- 8: Prüfen, ob die bestimmte Zuverlässigkeit des vereinfachten Modells den festgelegten Schwellenwert überschreitet
- 9: falls die bestimmte Zuverlässigkeit des vereinfachten Modells den festgelegten Schwellenwert überschreitet, Ausgeben des vereinfachten Modells
- 11: XiL-Modell A
- 12: XiL-Modell B
- 13: XiL-Modell C

- 14: Fahrzeughardware-Komponente
- 15: vereinfachtes XiL-Modell
- 20: Anordnung zur Durchführung von XiL-Tests
- 21: XiL-System
- 22: Einrichtung zum Vereinfachen eines Modells mittels eines tiefen neuronalen Netzwerks
- 23: neu generiertes XiL-System
- 30: Anordnung zur Durchführung von XiL-Tests
- 31: XiL-System
- 32: Einrichtung zum Vereinfachen eines Modells mittels eines rekurrenten neuronalen Netzwerks
- 33: neu generiertes XiL-System
- 41: XiL-Modell A
- 42: XiL-Modell B
- 43: XiL-Modell C
- 44: XiL-Modell D
- 45: vereinfachtes XiL-Modell
- 50: Start
- 51: XiL-System initialisieren
- 52: Eingangs- und Ausgangsdaten von komplexem Modell generieren
- 53: Trainieren eines neuronalen Netzwerks
- 54: Testen des erzeugten Modells in Bezug auf seine Zuverlässigkeit
- 55: Grenzwert für Zuverlässigkeit überschritten?
- 56: komplexes XiL-Modell durch AI-basiertes XiL-Modell ersetzen
- 57: Anwendung des XiL-Systems starten
- 58: Ende
- J: ja
- N: nein

## Patentansprüche

1. Verfahren zum Erzeugen eines vereinfachten Models zur Anwendung in einem XiL-System, wobei das Verfahren folgende Schritte umfasst:
- Bestimmen mindestens eines festgelegten Parameters, welcher die Komplexität eines Modells quantitativ charakterisiert, für mindestens ein Ausgangsmodell (1),
- Generieren von Eingangsdaten und Ausgangsdaten des mindestens einen Ausgangsmodells (2),
- Trainieren eines neuronalen Netzwerks mittels einer Trainingsmenge der generierten Eingangsdaten und Ausgangsdaten des mindestens einen Ausgangsmodells zur Erzeugung eines vereinfachten Modells, welches im Vergleich zu dem mindestens einen Ausgangsmodell eine geringere Komplexität aufweist und bei welchem ein festgelegter unterer Schwellenwert für mindestens einen die Zuverlässigkeit eines Modells quantitativ charakterisierenden Parameter überschritten wird (3),
- Erzeugen eines vereinfachten Modells mittels des trainierten neuronalen Netzwerks (4),
- Bestimmen des mindestens einen, die Komplexität charakterisierenden Parameters für das vereinfachte Modell (5),
- falls die bestimmte Komplexität des erzeugten vereinfachten Modells geringer ist als die des Ausgangsmodells (6), Testen des erzeugten vereinfachten Modells mittels einer von der Trainingsmenge abweichenden Testmenge der generierten Eingangsdaten und Ausgangsdaten des mindestens einen Ausgangsmodells und Bestimmen des mindestens einen, die Zuverlässigkeit charakterisierenden Parameters des erzeugten vereinfachten Modells (7),
- falls die bestimmte Zuverlässigkeit des vereinfachten Modells den festgelegten Schwellenwert überschreitet (8), Ausgeben des vereinfachten Modells (9).

2. Verfahren nach Anspruch 1,
**dadurch gekennzeichnet, dass**
der Parameter, welcher die Komplexität des Ausgangsmodells quantitativ charakterisiert, die Anzahl der Rechenoperationen pro Eingangsdatum und/oder die erforderliche Rechenzeit zur Ausführung eines das Modell abbildenden Algorithmus und/oder den erforderlichen Speicherplatzbedarf zur Ausführung eines das Modell abbildenden Algorithmus umfasst.

3. Verfahren nach Anspruch 1 oder 2,
**dadurch gekennzeichnet, dass**
der Parameter, welcher die Zuverlässigkeit des Ausgangsmodells quantitativ charakterisiert, ein Maß für die Abweichung der durch das Modell erzeugten Ausgangsdaten von erwarteten Ausgangsdaten umfasst.

4. Verfahren nach einem der Ansprüche 1 bis 3,
**dadurch gekennzeichnet, dass**
das neuronale Netzwerk als tiefes neuronales Netzwerk ausgestaltet ist.

5. Verfahren nach einem der Ansprüche 1 bis 4,
**dadurch gekennzeichnet, dass**
das mindestens eine Ausgangsmodell als Sequenz aus einer Anzahl an Modellen ausgestaltet ist.

6. Verfahren nach einem der Ansprüche 1 bis 5,
**dadurch gekennzeichnet, dass**
das neuronale Netzwerk als rekurrentes neuronales Netzwerk ausgestaltet ist.

7. Verfahren nach einem der Ansprüche 1 bis 6,
**dadurch gekennzeichnet, dass**
das Verfahren zum Erzeugen eines Modells zur Simulation von mindestens einer Funktion eines Kraftfahrzeugs ausgelegt ist.

8. Vorrichtung zur Datenverarbeitung (22, 32), umfassend Mittel zur Ausführung des Verfahrens nach einem der Ansprüche 1 bis 7.

9. Vorrichtung (22, 32) nach Anspruch 8,
**dadurch gekennzeichnet, dass**
die Vorrichtung als Hardware-Element ausgestaltet ist, welches eine RechenEinheit zur Ausführung neuronaler Netzwerk Algorithmen umfasst und zur Verbindung mit einer Anzahl an XiL-Einheiten ausgelegt ist.

10. Anordnung zur Durchführung von XiL-Tests (20, 30) von Komponenten von Kraftfahrzeugen, welche/s eine Mehrzahl an zur Datenübertragung miteinander verbundenen XiL-Modellen (11 - 14, 41 - 44) umfasst, **dadurch gekennzeichnet, dass**
die Anordnung (20, 30) dazu ausgelegt ist, mindestens eins der XiL-Modelle (11 - 14, 41 - 44) durch ein mittels eines Verfahrens gemäß einem der Ansprüche 1 bis 7 erzeugtes vereinfachtes XiL-Modell (15, 45) zu ersetzen, wobei die Anordnung (20, 30) optional zusätzlich dazu ausgelegt ist, mehrere der XiL-Modelle (42, 43) durch ein einzelnes mittels eines Verfahrens gemäß einem der Ansprüche 1 bis 7 erzeugtes vereinfachtes XiL-Modell (45) zu ersetzen.

11. Anordnung (20, 30) nach Anspruch 10,
**dadurch gekennzeichnet, dass**
die Anordnung (20, 30) eine Vorrichtung (22, 32) gemäß Anspruch 8 und/oder ein Computerprogramm umfasst, welches Befehle umfasst, die bei der Ausführung des Programms durch einen Computer diesen veranlassen, ein Verfahren nach einem der Ansprüche 1 bis 7 auszuführen.

12. Verfahren zur Durchführung von XiL-Tests, umfassend die Schritte:
- Initialisieren eines XiL-Systems, welches mindestens ein Ausgangsmodell (11-14, 41-44) umfasst, (51)
- Erzeugen eines vereinfachten Modells (15, 45) mindestens eines Ausgangsmodells (12, 42, 43) gemäß einem Verfahren nach einem der Ansprüche 1 bis 7, (52 - 55)
- Ersetzen des mindestens einen Ausgangsmodells (12, 42, 43) durch das vereinfachte Modell in dem XiL-System, (56)
- Durchführen des XiL-Tests mit dem das vereinfachte Modell umfassenden XiL-System (57).

13. Computerprogramm, umfassend Befehle, die bei der Ausführung des Programms durch einen Computer diesen veranlassen, ein Verfahren nach einem der Ansprüche 1 bis 7 oder ein Verfahren zur Durchführung von XiL-Tests nach Anspruch 12 auszuführen.

14. Computerlesbares Speichermedium, umfassend Befehle, die bei der Ausführung durch einen Computer diesen veranlassen, ein Verfahren nach einem der Ansprüche 1 bis 7 und/oder ein Verfahren nach Anspruch 12 auszuführen.

15. Datenträgersignal, das das Computerprogramm nach Anspruch 13 überträgt.
